(19) Europäisches Patentamt
European Patent Office
Office européen des brevets

(11) Publication number: **0 087 262**
**A1**

(12) **EUROPEAN PATENT APPLICATION**

(21) Application number: 83300749.5

(22) Date of filing: 15.02.83

(51) Int. Cl.³: G 03 C 1/52
G 03 C 1/56, G 03 C 1/72
H 05 K 3/06, G 03 F 7/08
G 03 F 7/26, H 01 L 21/312
H 01 L 21/47

(30) Priority: 22.02.82 US 350737

(43) Date of publication of application: 31.08.83 Bulletin 83/35

(84) Designated Contracting States: DE FR GB IT

(71) Applicant: MINNESOTA MINING AND MANUFACTURING COMPANY
3M Center
Saint Paul, Minnesota 55101(US)

(72) Inventor: Cederberg, Barbara M.
2501 Hudson Road P.O. Box 33427
St. Paul Minnesota 55133(US)

(72) Inventor: Fisch, Richard S.
2501 Hudson Road P.O. Box 33427
St. Paul Minnesota 55133(US)

(74) Representative: Bowman, Paul Alan et al,
LLOYD WISE, TREGEAR & CO. Norman House 105-109 Strand
London WC2R OAE(GB)

(54) **Positive acting photosensitive compositions.**

(57) A positive acting light sensitive photoresist composition comprising:

a) a crosslinked urethane resin comprising 40 to 80 percent by weight of a first non-heat reactive novolak phenolic resin, 5 to 50 percent by weight of a second non-heat reactive novolak phenolic resin having an alkyl group of at least 3 carbon atoms bonded to the aromatic ring of the phenolic group, and 1 to 40 percent by weight of the total weight of novolak phenolic resin of a polyisocyanate, and

b) 10 to 50 percent by weight of a positive activing photosensitizer.

EP 0 087 262 A1

0087262

# POSITIVE ACTING PHOTOSENSITIVE COMPOSITIONS AND IMAGEABLE ARTICLES CONTAINING SAME

Positive acting photoresist compositions and films have utility in numerous commercial areas. They can be used in the manufacture of electronic circuitry and printing plates, and can be used in image forming systems. These positive systems generally rely on positive acting photosensitizers as the photoactive component. Positive acting photosensitizers are compounds which are substantially insoluble in a given solvent and which become more soluble in that solvent after being struck by radiation to which the photosensitizer is sensitive. The photosensitizers are generally carried in an organic polymeric binder to provide physical integrity to the radiation sensitive layer.

U.S. Patent Nos. 3,782,939 and 4,193,797 teach the use of dry film photoresists using positive acting aromatic diazo compounds as the positive acting photoresist. These compounds are generally disclosed as aromatic o-diazo quinones, preferably naphthalene compounds.

U.K. Patent No. 941,835 and U.S. Patent Nos. 3,046,120, 3,046,121 and 3,211,553 disclose the use of positive acting aromatic diazonium salt-phenol formaldehyde condensation products as photosensitizers in printing plate compositions to form hard, durable, insoluble surfaces that retain an ink coating.

U.S. Patent No. 4,247,616 shows improved positive acting photoreactive compositions novolak resins cured with polyisocyanates, positive acting photosensitizers, and epoxy resin. The novolaks (phenol formaldehyde condensates) may be present in concentrations of fifty percent or higher. These compositions are particularly useful as dry film photoresists.

Positive acting layers made with phenol formaldehyde resins are used as printing plates, wet or dry microcircuitry resists, lithographic film or the like.

Lithographic film substitutes presently rely on a photosensitive layer of o-diazo quinones and novolak resin on a thin metal layer vapor coated onto a film base, usually a transparent base. The light-sensitive layer on the metal film, after imagewise exposure and development by a highly alkaline developer solution, acts as a photoimaged etching mask over the metal layer. Etching of the metal areas no longer protected by the resin layer provides a positive image. Any fracturing of the diazo oxide-phenol formaldehyde photosensitive layer presents a path for the developer to travel through and etch the metal layer. This creates image effects in undesired areas and reduces the usefulness of the imageable sheet. Such fractures can be caused by handling, especially manipulations causing a kink, crease or permanent bend of the support and/or metal layer carrying the photosensitive layer. Positive acting compositions comprising diazo oxides and phenol formaldehyde resins are particularly prone to this deficiency because of inherent brittleness.

Several techniques have been used to minimize this fracture deficiency including the addition of rosins and plasticizers (U.S. Patent No. 4,148,654). This remedy is only partially effective since the quantities of rosin and plasticizer needed to improve flexibility lower the resistance of the unexposed coating to the types of alkaline developer used with the compositions. The plasticizers also tend to leach out on storage to coat the surface of the photosensitive layer. The inclusion of an epoxy resin into the composition (U.S. Patent No. 4,247,616) produces only a slightly more flexible coating after complete curing of the epoxy. This epoxy cure, however, is such that the photosensitive layer becomes undevelopable.

## BRIEF DESCRIPTION OF THE INVENTION

A storage stable, flexible, durable positive acting photosensitive composition has been formed of a mixture comprising a) a crosslinked urethane resin formed from a non-heat reactive novolak phenol-formaldehyde resin, a flexible non-heat reactive novolak formed from an alkyl phenol and a polyisocyanate, and b) a positive acting photosensitizer.

## DETAILED DESCRIPTION OF THE INVENTION

Positive acting photosensitive compositions according to the present invention typically comprise a crosslinked urethane resin comprising from about 40 to 80 percent by weight of a first non-heat reactive novolak phenolic resin, 5 to 50 percent by weight of a second non-heat reactive novolak resin which is a flexible novolak resin and 10 to 50 percent by weight positive acting photosensitizer. Preferred novolaks of both classes include resins having a molecular weight of 300 to 2000 or more preferably 500 to 1000, the first resin including those of U.S. Patent No. 4,148,655. All weight percentages are with respect to the ingredients in the composition, excluding essentially inert materials such as solvents, dyes, pigments, coating aids, and the like.

'Non-heat reactive,' as applied to materials of the present invention, means that the resin, when heated alone, will not increase its molecular weight by 10% or more when heated to 250°F (121°C) for four hours. Preferably the material will not increase its molecular weight by 4%, 2% or even less.

The flexible, non-heat reactive novolak is the reaction product of formaldehyde and an alkyl phenol. The alkyl phenol comprises a phenol having at least one alkyl group (in the m-, o-, or p- position) of at least three carbon atoms. Preferably the alkyl group has from three to twenty carbon atoms. More preferably the alkyl group has from five to seventeen carbon atoms. It is most preferable

to have the alkyl group meta to the hydroxy of the phenol. The alkyl may be branched, cyclic or straight-chained, and may be variously substituted. Typical substitution would be halogen, alkyl, alkoxy, or hydroxy groups. The preferred novolaks of alkyl phenols are capped with compounds such as alkylene oxides. Such novolaks include distilled cashew nut shell liquid/formaldehyde resins having a molecular weight of at least 300. The incorporation of alkyl phenol novolaks which contain functional groups reactive with isocyanates also greatly increases the cohesive strength of the film and its ability to adhere to the substrate. The first novolak is not a flexible novolak and does not contain an alkyl group of at least 3 carbon atoms on the phenol. Preferably the first novolak is unsubstituted on the phenol.

Polyisocyanates useful herein include conventional aromatic and aliphatic polyisocyanates. Preferably, the polyisocyanates are of long chain length, i.e., where the isocyanate groups are connected by linkages of from about 10 to about 40 or 50 carbon atoms. Both smaller (e.g., 4 or 6 carbon atoms) and larger chain aromatic and aliphatic diisocyanates would of course still be useful in the practice of the present invention. For example, isophoronediisocyanate, toluene diisocyanate and other diisocyanates are particularly useful. The polyisocyanate should preferably be present in a concentration of from about 1 to 40 parts and preferably from about 6 to about 15 parts by weight per 100 parts of novolak resin present, depending upon the molecular weight or isocyanate equivalent weight of the polyisocyanate. In general, the weight percent should not exceed a range of from about 2 to 25 or 3 to 20 percent by weight of the total amount of novolak resin. Decreasing amounts tend to cause the resultant film to be excessively brittle, to have insufficient internal strength, and, in the case of photoresists, to exhibit reduced adhesion to the substrate to which the film is adhered. Increased amounts tend to cause the film

to fail to clean out in exposed areas during development. Any catalyst known to be useful in the catalysis of urethane formation may be used. The most preferred catalysts include metal salts of organic acids and tertiary amines, examples of which include stannous octoate, stannous hexanoate, 1,4-diazabicyclo-(2,2,2)- octane, and 2,4,6-tris(dimethylaminomethyl) phenol.

Catalyst concentration is not critical, as long as a sufficient amount is present to insure crosslinking. typically, greater than about 0.05 parts by weight per 100 parts of novolak resin is more than sufficient to insure complete crosslinking, although as little as 0.01 parts can be sufficient.

Once the urethane formation is complete, a polymerizable epoxy resin having an epoxide equivalent weight of less than about 400 may be added to the solution, along with a curing agent therefor in addition to the flexible novolak. A typical and preferred epoxy resin is diglycidyl ether of bisphenol A. Epoxy resin concentrations could be from zero to about 40 parts by weight per 100 parts of the total weight of novolak resin. The inclusion of limited quantities of epoxy adds, only slightly, to the cohesive strength of the dry resist.

Exemplary epoxy curing agents include aliphatic or aromatic amines, aliphatic or aromatic anhydrides, disulfones, nitriles, and other known epoxy curing agents. Any of these and other curing agents may be used in the practice of the present invention. Preferred curing agents include phthalic anhydride, diamino diphenylsulphone or a combination thereof. Typically, from about 5 to about 50 parts of curing agent per 100 parts of epoxy resin are sufficient to insure curing of the epoxy.

In order to insure the greatest amount of shelf life, a stable catalyst for the crosslinking should be used. A stable catalyst is one which in the presence of a novolak resin does not cause the molecular weight of the novolak to increase by 10% or more in 24 hours at room

temperature. Preferably the novolak would not increase its molecular weight by more than 4% or even 2% in the presence of a stable catalyst.

The positive-acting photosensitizer is conveniently added by thorough mixing to the solution containing the urethane (derived from the diisocyante, novolak and flexible novolak and the catalyst for the urethane formation) and the optional polymerizable epoxy resin and epoxy curing agent. Exemplary photosensitizers include diazo oxides, as known in the art, e.g., naphthoquinone-1,2-diazide-(2)-5-sulfonic-p-methylphenyl ester, as in U.S Patent Nos. 3,046,120; 3,046,121; and 3,211,553, and diazo sulfones as known in the art, e.g., in U.S. Patent Nos. 2,465,760; 3,113,865; and 3,661,573; and U.K. Patent No. 1,277,428. The photosensitizers should be soluble in the solvent utilized for the coating solution applications. A particularly useful photosensitizer which is commercially available under the tradename "Diazo 11", is a naphthoquinone-(1,2)-diazide- sulfonic-(5)-naphthadiester available from the Molecular Rearrangement Company. The positive acting photosensitizers of U.S. Patent No. 4,148,654 are also useful in the present invention. A positive acting photosensitizer according to the present invention is a material which when struck by actinic radiation decomposes into a material which is more acidic than the photosensitizer. Preferably the original photosensitizer is neutral or basic to provide the greatest change in pH. The photosensitizer component need not provide any structural integrity by itself as it is blended into the mixture of urethane, optional epoxy resin and epoxy curing agent. Solvents utilized in the formation of the photosensitive solution are a matter of choice and convenience, and include, for example, methyl isobutyl ketone, methyl ethyl ketone, etc.

In practice, the solution can be simply coated by any known means onto a support material, followed by drying at a temperature sufficient to form the urethane and cure

the epoxy resin, if present.

The positive-acting photosensitive composition can be coated onto other support materials. For example, a metal plate such as aluminum, zinc, or copper, a plastic film such as polyester, polypropylene, cellulose acetate, paper or; a laminate of paper with one or more of the above mentioned films is useful in forming a photosenitive layer haveing a useful thickness.

Furthermore, the liquid photosensitive solution can be coated onto stainless steel for the purpose of manufacturing bimetallic printing plates by means of electrode deposition subsequent to imaging and development of the light sensitive material, or can be applied onto aluminum and silicated aluminum to manufacture printing plates, since the dry composition is oleophilic in nature.

Exposure of the photosensitive film layer can be carried out by conventional techniques, e.g., carbon arc, xenon flash, ultraviolet radiation, etc., depending upon the radiation to which the photosensitizer is sensitive. Image development is performed by using an alkali developing liquid, for example, an aqueous solution of sodium hydroxide, sodium carbonate, sodium metasilicate alone or in a mixture of two or more of the above mentioned compounds, or preferably the developers disclosed in U.S. Patent No. 4,314,022.

The invention will now be more specifically described by the aid of the following non-limiting examples.

Example 1

A diazo oxide-phenol formaldehyde photoresist composition was prepared by mixing the following components:

| | (grams) |
|---|---|
| methyl ethyl ketone | 17.3 |
| *DMP-30 | 0.22 |
| *Resinox 7280 | 6.9 |
| *DD1-1410 | 0.62 |
| *Calco Yellow | 0.0075 |
| *Oil Soluble Blue G | 0.025 |

After mixing for four hours, the following compounds were added:

| | (grams) |
|---|---|
| *Epon 828 | 1.6 |
| Diazo oxide | 2.5 |
| methyl ethyl ketone | 20.95 |

*DMP-30 - Tradename for Dimethylaminomethyl phenol, formula wt. 265 sold by Rohm & Haas Co.

*Resinox 7280 - Tradename for phenol/formaldehyde (novolak) resin available from Monsanto

*DD1-1410 - Tradename for an aliphatic diisocyanate from General Mills Chemicals, Inc.

*Calco Yellow - American Cyanamide Co.

*Oil Soluble Glue G - Tradename - Capital Color Chemical Co.

*Epon Resin 828 - Tradename for epichlorohydrin/bisphenol A-type, low molecular weight epoxy resin sold by Shell Chemical Co.

The resultant mixture was coated onto an aluminum vapor coated 4 mil polyethylene terephthalate flexible film and oven dried at 230°F for 5 minutes.

The resultant coating had a flexibility measurement of 14mm. Flexibility is measured using an apparatus consisting of a 33mm wide Teflon® fixed position roller and an identical 35mm Teflon® roller whose distance from the fixed roller can be adjusted to a known spacing. The sample to be tested is cut into a 350mm long and 35mm wide band.

The ends of the band are held together with the photoresist on the outside and the band caused to pass between the rollers, attached end first. The rollers cause the bowed portion of the sample to be compressed to a specific angle of curvature, the distance between the rollers determining this angle of curvature. At some specific (roller to roller) distance the web curvature will produce a crack in the coating. This roller to roller distance can be used as an expression of the film brittleness.

A measurement of 10 or less is sufficient flexibility for a dry photoresist coated on a flexible support.

Imagewise exposure to UV light (15 sec in a 2kw Berkey-Ascor contact printer) followed by processing in 1.2% NaOH and 3% fo the tetrasodium salt of nitrilo triaretic acid (38°C) for 25 seconds in a rapid access processor with a water wash produced no image, i.e., the photoresist was too alkali soluble and allowed non-imagewise etching of the aluminum. Imagewise etching of the aluminum was possible after two months natural aging. Accelerated aging (20 hrs., 60°C) produced an overcured photoresist which would not imagewise develop.

## Example 2

The following formula produced a second photoresist coating solution:

| | (grams) |
|---|---|
| methyl ethyl ketone | 32.0 |
| *Resinox 7280 | 3.4 |
| Propoxylated novolak of distilled cashew nut shell liquid | 1.85 |
| *DD1-1410 | 0.60 |
| *Diazo oxide | 1.45 |
| *Calco Yellow | 0.006 |
| *Oil Soluble blue G | 0.02 |
| stannous octoate | 0.10 |
| tetra n-butyl phosphonium acetate | .20 |

The solution was coated and processed as described in Example 1. The coating cracked at a roller-to-roller distance of 8mm and after exposure and processing, an excellent dot-for-dot image was produced. Accelerated aging showed no sensitometric change.

Example 3

The following formula produced a third photoresist coating solution containing a reduced quantity of the flexible novolak resin:

| | (grams) |
|---|---|
| methyl ethyl ketone | 32.0 |
| *Resinox 7280 | 3.8 |
| Propoxylated novolak of distilled cashew nut shell liquid | 1.3 |
| *DD1-1410 | 0.60 |
| *Diazo oxide | 1.45 |
| *Calco Yellow | 0.006 |
| *Oil soluble blue G | 0.02 |
| stannous octoate | 0.10 |
| tetra n-butyl phosphonium acetate | 0.53 |

The solution was coated and processed as described in Example 1. The coating cracked at a roller-to-roller distance of 9mm and after exposure and processing, and excellent dot-for-dot image was produced. Accelerated aging showed no sensitometric change.

Example 4

The following formula produced a fourth photoresist coating solution containing an epoxy resin:

| | (grams) |
|---|---|
| methyl ethyl ketone | 32.0 |
| *Resinox 7280 | 3.4 |
| Propoxylated novolak of distilled cashew nut shell liquid | 1.85 |
| *DDl-1410 | 0.60 |
| *Epon 828 | 0.16 |
| *Diazo oxide | 1.45 |
| *Calco yellow | 0.006 |
| Oil soluble blue G | 0.02 |
| stannous octoate | 0.10 |
| tetra n-butyl phosphonium acetate | 0.20 |

The solution was coated and processed as described in Example 1. The coating cracked at a roller-to-roller distance of 9mm and after exposure and processing, an excellent dot-for-dot image was produced. Accelerated aging showed no sensitometric change.

Example 5

The following formula produced a fifth photoresist coating solution containing an ethoxylated instead of a propoxylated flexible novolak.

| | (grams) |
|---|---|
| methyl ethyl ketone | 32.0 |
| *Resinox 7280 | 3.8 |
| Ethoxylated novolak of distilled cashew nut shell liquid | 1.3 |
| *DDl-1410 | 0.60 |
| *Diazo Oxide | 1.45 |
| *Calco yellow | 0.006 |
| Oil soluble blue G | 0.02 |
| stannous octoate | 0.10 |
| tetra n-butyl phosphonium acetate | 0.53 |

The solution was coated and processed as described in Example 1. The coating cracked at a roller-to-roller

distance of 9mm and after exposure and processing, an excellent dot-for-dot image was produced. Accelerated aging showed no sensitometric change.

## Example 6

The following formula produced a sixth photoresist coating solution containing a non-capped flexible novolak.

| | (grams) |
|---|---|
| methyl ethyl ketone | 32.0 |
| Resinox 7280 | 3.8 |
| Novolak of distilled cashew nut shell liquid | 1.3 |
| DD1-1410 | 0.60 |
| Diazo oxide | 1.45 |
| Calco yellow | 0.006 |
| Oil soluble blue G | 0.02 |
| stannous octoate | 0.10 |
| tetra n-butyl phosphonium acetate | 0.53 |

The solution was coated and processed as described in Example 1. The coating cracked at a roller-to-roller distance of 9mm and after exposure and processing, an excellent dot-for-dot image was produced. Accelerated aging showed no sensitometric change.

For purposes of only providing an example, the structure of the propoxylated novalak of distilled cashew nut shell liquid is:

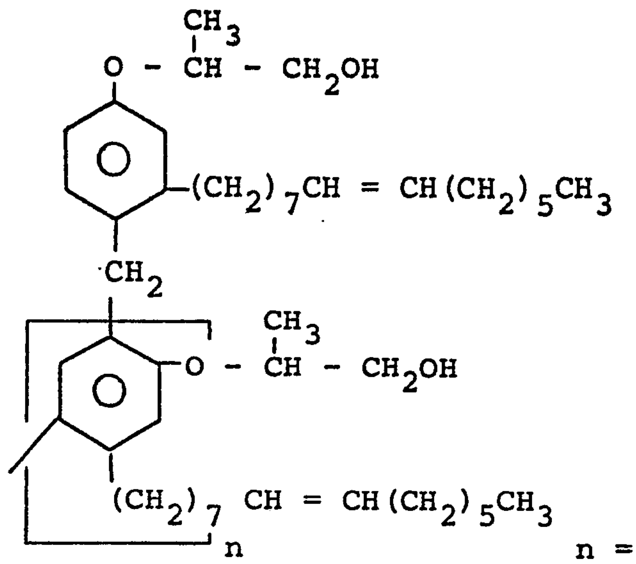

n = (3 - 5 units)

CLAIMS:

1. A positive acting light sensitive composition comprising:

a) a crosslinked urethane resin comprising 40 to 80 percent by weight of a first non-heat reactive novolak phenolic resin, 5 to 50 percent by weight of a second non-heat reactive novolak phenolic resin having an alkyl group of at least 3 carbon atoms bonded to the aromatic ring of the phenolic group, and 1 to 40 percent by weight of the total weight of novolak phenolic resin of a polyisocyanate, and

b) 10 to 50 percent by weight of a positive acting photosensitizer.

2. The composition of Claim 1, wherein said positive acting photosensitizer is a diazo oxide or a diazo sulfone.

3. The composition of Claim 1 wherein said positive acting photosensitizer is an aromatic o-diazo quinone.

4. The composition of Claim 1, wherein the phenolic group of the first non-heat reactive novolak phenolic resin is unsubstituted.

5. The composition of any preceding claim, wherein the phenolic group of the second non-heat reactive novolak resin has an alkyl group of from 3 to 20 carbon atoms bonded to the aromatic ring of the phenolic group.

6. The composition of Claim 5, wherein said positive acting photosensitizer is an aromatic o-diazo quinone and said polyisocyanate comprises 3 to 20 percent by total weight of said novolak phenolic resin.

7. The composition of any preceding claim, wherein said alkyl group of the second novolak phenolic resin has from 5 to 17 carbon atoms and is in the meta-position.

8. The composition of any preceding claim, wherein an epoxy resin in an amount up to 40 percent by weight of the novolak resin is present in the composition and an epoxy curing agent is present as from 5 to 50 percent by weight of the epoxy resin.

9. The composition of Claim 8, wherein a stable urethane crosslinking catalyst is present in the composition.

10. The composition of Claim 9, wherein said stable crosslinking catalyst comprises a metal salt of an organic acid and either a tertiary amine or tetra-alkyl phosphonium acetate.

11. An imageable article comprising a substrate, an etchable layer on at least one surface of said substrate, and a layer comprising the composition of any preceding claim is adhered to said etchable layer.

European Patent Office

# EUROPEAN SEARCH REPORT

0087262 Application number

EP 83300749.5

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 3) |
|---|---|---|---|
| A,D | US - A - 4 247 616 (VIKESLAND)<br>* Totality *<br>-- | 1,3,8,11 | G 03 C 1/52<br>G 03 C 1/56<br>G 03 C 1/72<br>H 05 K 3/06<br>G 03 F 7/08<br>G 03 F 7/26<br>H 01 L 21/312<br>H 01 L 21/47 |
| A,D | US - A - 4 148 654 (ODDI)<br>* Claims 1,18 *<br>-- | 1,3,11 | |
| A | FR - A1 - 2 309 896 (AMERICAN HOECHST)<br>* Claims *<br>-- | 1,3,11 | |
| A,D | GB - A - 1 277 428 (AGFA-GEVAERT)<br>* Claims *<br>-- | 1,2,11 | |
| A,D | US - A - 4 148 655 (ITOH)<br>* Abstract *<br>---- | 1 | |

| TECHNICAL FIELDS SEARCHED (Int. Cl. 3) |
|---|
| G 03 C |
| H 05 K |
| H 01 L |
| G 03 F |

The present search report has been drawn up for all claims

| Place of search | Date of completion of the search | Examiner |
|---|---|---|
| VIENNA | 27-05-1983 | SCHÄFER |

**CATEGORY OF CITED DOCUMENTS**

X : particularly relevant if taken alone
Y : particularly relevant if combined with another document of the same category
A : technological background
O : non-written disclosure
P : intermediate document
T : theory or principle underlying the invention
E : earlier patent document, but published on, or after the filing date
D : document cited in the application
L : document cited for other reasons

& : member of the same patent family, corresponding document